# EUROPEAN PATENT APPLICATION

(11) **EP 2 842 439 A1**
(43) Date of publication of application: **04.03.2015**
(21) Application number: 13782251.6
(22) Date of filing: 05.03.2013
(51) Int. Cl.: A41D 27/00, A41D 1/06, A41D 1/14

(54) **METHOD FOR MANUFACTURING NONSLIP MEMBER FROM SILICONE RESIN, NONSLIP MEMBER MANUFACTURED USING SAME METHOD, AND QUARTER LINING WITH NONSLIP MEMBER ATTACHED**

(30) Priority: 24.04.2012 JP 2012098560
(71) Applicant: Hassho Shoji Co., Ltd., Osaka-shi, Osaka 536-0021 (JP)
(72) Inventor: OGAWA, Toshio, Osaka-shi Osaka 536-0021 (JP)
(74) Representative: Glawe, Delfs, Moll
(86) International application number: PCT/JP2013/001352
(87) International publication number: WO 2013/161151

(57) **Abstract**

A surface of a nonslip member (1) made of a silicone resin is treated by combustion chemical vapor deposition (2). A two pack urethane-based primer (3) in the molten state is applied to the surface of the nonslip member (1) treated by combustion chemical vapor deposition (2). The primer (3) is dried, and a thermal adhesive resin film (4) is applied to the layer of the primer 3 by thermal adhesion treatment. The adhesiveness (adhesive strength) of the nonslip member (1) made of a silicone resin is substantially improved. Therefore, when a nonslip member (A) is attached to the underside of the waist of a pair of trousers or a skirt or to a quarter lining attached to that part, the nonslip member (A) can maintain an extremely excellent nonslip effect for a long time. In addition, the nonslip member (A) does not peel off after washing or dry cleaning.

## Description

### Technical Field

The present invention relates a method of manufacturing a nonslip member made of a silicone resin, and a nonslip member manufactured in the same method. The present invention also relates to a quarter lining with the nonslip member attached thereto.

### Background Art

A thermal adhesive resin in a molten state can be directly applied to a nonslip member made of a silicone resin to form a nonslip member with a thermal adhesive resin film applied thereto. This process is technically feasible. However, in a situation where the nonslip member is bonded to clothes for use, the nonslip member can hardly have enough adhesiveness to withstand repetitions of washing or dry cleaning.

To overcome the drawback, there is a technique of impregnating a reinforcing piece of fabric or knit with a nonslip member in the molten state and a thermal adhesive resin in the molten state when the nonslip member is in the molten state and yet to be molded and the thermal adhesive resin is in the molten state, thereby increasing the adhesiveness of the nonslip member molded and cured and the thermal adhesive resin film cured (Patent Literature 1, for example).

### Citation List

### Patent Literature

Patent Literature 1: Japanese Patent No. 3417836 (see Claims and paragraph [0007], for example)

### Summary of Invention

### Technical Problem

This technique requires the reinforcing piece to be impregnated with the nonslip member in the molten state and the thermal adhesive resin in the molten state and has a drawback that not only the thickness but also the cost of the nonslip member increases accordingly.

The drawback can be readily overcome if the thermal adhesive resin film can be directly applied to the nonslip member made of a silicone resin without the reinforcing piece.

An object of the present invention is to provide a method of manufacturing a nonslip member that can meet the demand, and a nonslip member manufactured in the same method. Another object of the present invention is to provide a quarter lining with the nonslip member attached thereto.

### Solution to Problem

A method of manufacturing a nonslip member made of a silicone resin according to the present invention is characterized in that a surface of a nonslip member 1 made of a silicone resin is treated by combustion chemical vapor deposition, a two pack urethane-based primer 3 in a molten state is applied to the treated surface of the nonslip member 1 and dried, and a thermal adhesive resin film 4 is applied to the layer of the primer 3 by thermal adhesion treatment.

The combustion chemical vapor deposition (CCVD) is a process for oxidizing the surface of the nonslip member 1 by using the oxidizing power of flames at high temperature and a chemical reaction in flames and depositing a product of thermal decomposition, oxidation, reduction, polymerization or other chemical reaction of an organic compound in the flames on the surface of the nonslip member 1.

For example, a burner emitting flames at a high temperature of approximately 1000°C is moved four times (moved back and forth twice) over the surface of the nonslip member 1 to be treated at a speed of 900 mm/sec to apply the flames to the surface of the nonslip member 1. The surface of the nonslip member 1 exposed to the flames from the burner then rises to approximately 80°C for a moment, and therefore, the combustion chemical vapor deposition process occurs, and the chemical reaction product is deposited on the surface of the nonslip member 1.

The two pack urethane-based primer 3 in the molten state is applied to the surface of the nonslip member 1 treated by combustion chemical vapor deposition. The two pack urethane-based primer 3 is manufactured by synthesis of a urethane resin by reaction of a base resin and a curing agent. According to the most popular synthetic method, a polyol compound is used as a major constituent of the base resin, and an isocyanate compound is used as a major constituent of the curing agent. The nonslip member 1 made of a silicone resin and the thermal adhesive resin film 4 can be firmly bonded to each other by applying this two pack urethane-based primer 3 in the molten state to the surface of the nonslip member 1 treated by combustion chemical vapor deposition, drying the primer 3, and applying the thermal adhesive resin film 4 to the layer of the primer 3 by thermal adhesion treatment.

Possible reasons for the firm adhesion between the nonslip member 1 made of a silicone resin and the thermal adhesive resin film 4 are that the coating of the dried and cured two pack urethane-based primer 3 provides the nonslip member 1 serving as a base material with excellent adhesive properties, and that the coating has high flexibility. The temperature at which and the duration (dry time) for which the two pack urethane-based primer 3 in the molten state is dried are preferably approximately 80°C and 20 minutes, respectively.

Specific examples of the primer 3 include RUX manufactured by Seiko advance Ltd., SP-3100AU Clear manufactured by Teikoku Printing Inks Mfg. Co. Ltd., and AP ink and APG ink manufactured by Jujo Chemical Co. Ltd., for example. These are classified as two pack urethane-based primers. RUX manufactured by Seiko advance Ltd contains at least a polyurethane resin, isophorone and methyl ethyl ketone as major constituents and also contains some amount of ester.

According to this manufacturing method, one surface of the nonslip member 1 made of a silicone resin is treated by a surface treatment referred to as combustion chemical vapor deposition, the two pack urethane-based primer 3 in the molten state is applied to the surface subjected to the surface treatment, the primer 3 is dried, and the thermal adhesive resin film 4 is applied to the layer of the primer 3 by thermal adhesion treatment. Therefore, compared with the case where this primer 3 is not used (a case where a primer that is not the two pack urethane-based type is applied, for example), the adhesiveness (adhesive strength) of the nonslip member made of a silicone resin is substantially improved. Therefore, when the nonslip member A manufactured as described above is attached to the underside of the waist of a pair of trousers or a skirt or to a quarter lining B attached to that part, the nonslip member A can maintain an extremely excellent nonslip effect for a long time. In addition, the nonslip member A does not peel off after washing or dry cleaning.

The nonslip member A manufactured in the manufacturing method was mounted on fabric with an iron, a presser or other equipment to prepare a sample (having a size of 18 mm by 45 mm, referred to simply as a sample according to the present invention hereinafter). Table 1 shows the results of tests for the peel strength and the dry cleaning resistance of the sample according to the present invention. In addition, a nonslip member manufactured without using the two pack urethane-based primer 3 was mounted on fabric in the same manner as described above to prepare a sample (having a size of 18 mm by 45 mm, referred to simply as a sample of a conventional item hereinafter). Table 2 shows the results of tests for the peel strength and the dry cleaning resistance of the sample of the conventional item.

**[Table 1]**

| (SAMPLE ACCORDING TO PRESENT INVENTION) | | |
|---|---|---|
| TEST | CLASS | RESULT |
| PEEL STRENGTH | 1.-5. | NO PEEL AND UNMEASURABLE |
| DRY CLEANING RESISTANCE (COMMERCIAL DRY CLEANING (PETROLEUM-BASED)) | CHANGE IN COLOR (RANK) | 4 - 5 |
| | CHANGE IN SHAPE | NO CHANGE OBSERVED |

**[Table 2]**

| (SAMPLE OF CONVENTIONAL ITEM) | | |
|---|---|---|
| TEST | CLASS | RESULT |
| PEEL STRENGTH | 1. | 3550 (cN) |
| | 2. | 1768 (cN) |
| | 3. | 1550 (cN) |
| | 4. | 1514 (cN) |
| | 5. | 1086 (cN) |
| | AVERAGE | 1894 (cN) |
| DRY CLEANING RESISTANCE (COMMERCIAL DRY CLEANING (PETROLEUM-BASED)) | CHANGE IN COLOR (RANK) | 4-5 |
| | CHANGE IN SHAPE | PEEL OBSERVED |

The peel strength test was conducted for the sample according to the present invention and the sample of the conventional item having the same size (18 mm by 45 mm) in conformity with the strength testing method according to Japanese Industrial Standards (JIS) L 1086 (2008). In the strength testing method according to JIS, a 5-mm-long end part of the nonslip member of each sample was peeled off the fabric, the peeled part (a gripping part having a size of 5 cm by the width of the sample) was held by a constant-rate-of-extension tensile tester and pulled at a uniform rate of 10 cm/min. The test was conducted for five of each sample, and the data was compiled (the average was calculated).

The dry cleaning resistance test was conducted for the sample according to the present invention and the sample of the conventional item having the same size (18 mm by 45 mm) in conformity with the dry cleaning testing method according to JIS L 0860 (2008) B-1 (petroleum-based dry solvent). In the dry cleaning testing method according to JIS, 100 ml of an industrial gasoline No. 5 testing liquid was poured into a testing bottle, 20 stainless steel balls were put in the same testing bottle. After the temperature of the testing liquid was adjusted to 30 ± 2°C, each sample was put in the testing bottle. The testing bottle was then sealed and placed in a tester, and the tester was operated for 30 minutes. The appearance of each sample after commercial dry cleaning (petroleum-based dry solvent) was evaluated in terms of the degree of change in color and the degree of change in shape. In this case, the samples were dried by tumble drying, which involves rolling (and sometimes shaking) the samples under heat.

As can be seen from comparison of Tables 1 and 2, the test results of the five samples according to the present invention were "NO PEEL AND UNMEASURABLE".

To the contrary, the test results of the five samples of the conventional item were 3550, 1768, 1550, 1514 and 1086 in terms of ultimate strength (in units of cN), and the average was 1894 (cN).

As demonstrated by the test results, the sample according to the present invention, or in other words, the nonslip member manufactured according to the present invention does not peel off in the peel strength test.

Furthermore, as can be seen from comparison of the test results of the dry cleaning resistance in Tables 1 and 2, the sample according to the present invention and the sample of the conventional item were both 4 to 5 in terms of the change in color (rank) and were on a par with each other. However, in terms of the change in shape, the test result of the sample according to the present invention was "NO CHANGE OBSERVED", while the test result of the sample of the conventional item was "PEEL OBSERVED". Thus, in the dry cleaning resistance test, there was a significant difference between the sample according to the present invention and the sample of the conventional item. As demonstrated by the test results, the sample according to the present invention, or in other words, the nonslip member manufactured according to the present invention does not peel off in the dry cleaning resistance test.

The method of manufacturing a nonslip member according to the present invention does not involve any base material referred to as a reinforcing piece used in the technique described in Japanese Patent No. 3417836, for example. Therefore, the method can manufacture a nonslip member that is substantially thinner than the nonslip members manufactured in the conventional methods and is not uncomfortable for users.

When the thermal adhesive resin film 4 is applied to the layer of the primer 3 by thermal adhesion treatment, the thermal adhesive resin film 4 is desirably vertically pressed against the layer of the primer 3 with a roller or other pressing member. According to this manufacturing method, when the two pack type urethane-based primer 3 in the molten state between the nonslip member 1 made of a silicone resin and the thermal adhesive resin film 4 and the thermal adhesive resin film 4 are heated in thermal adhesion treatment, the pressing member can strongly and uniformly press the two layers against each other, so that the nonslip member 1 made of a silicone resin and the thermal adhesive resin film 4 are in more intimate contact with each other and can be more firmly bonded to each other. In addition, any bubble between the primer 3 and the thermal adhesive resin film 4 can be expelled by the pressure from the pressing member, so that the appearance of the nonslip member is also improved. The temperature at which and the duration for which the pressing member presses the two layers against each other are preferably approximately 110°C and 10 sec, respectively.

A nonslip member according to the present invention is characterized in that the nonslip member comprises a nonslip member 1 made of a silicone resin a surface of which is treated by combustion chemical vapor deposition, a layer of a two pack urethane-based primer 3 provided on the treated surface, and a thermal adhesive resin film 4 applied to the layer of the primer 3. With the nonslip member, since the nonslip member 1 made of a silicone resin and the thermal adhesive resin film 4 are firmly bonded to each other, when the nonslip member A is attached to the underside of the waist of a pair of trousers or a skirt or to a quarter lining B attached to that part, the nonslip member A can maintain an extremely excellent nonslip effect for a long time. In addition, the nonslip member A does not peel off after washing or dry cleaning. In addition, the nonslip member according to the present invention does not include any base material referred to as a reinforcing piece used in the technique described in Japanese Patent No. 3417836, for example. Therefore, the nonslip member can be substantially thinner than the nonslip members manufactured in the conventional methods and is not uncomfortable for users.

Preferably, the nonslip member has the shape of a sheet having a wide area, and the sheet-shaped member A' is processed into a predetermined size or thickness with a cutting die, an embossing die or other equipment. In this case, the nonslip member A, which is relatively small, can be extremely simply and efficiently manufactured from the sheet-shaped member having a wide area.

The quarter lining B according to the present invention is a quarter lining in which a nonslip member A is mounted on a belt body 5 to be attached to an underside of a waist of a pair of trousers or a skirt, the nonslip member A comprising a nonslip member 1 made of a silicone resin a surface of which is treated by combustion chemical vapor deposition, a layer of a two pack urethane-based primer 3 provided on the treated surface, and a thermal adhesive resin film 4 applied to the layer of the primer 3. When the quarter lining B is attached to the underside of the waist of a pair of trousers or a skirt, the nonslip member can maintain an extremely excellent nonslip effect for a long time. In addition, the nonslip member does not peel off after washing or dry cleaning.

### Advantageous Effects of Invention

With the manufacturing method according to claim 1, compared with the manufacturing method that does not involve applying the two pack urethane-based primer (the manufacturing method that involves applying a primer that is not the two pack urethane-based primer, for example), the adhesiveness (adhesive strength) of the nonslip member made of a silicone resin is substantially improved. Therefore, when the nonslip member A is attached to the underside of the waist of a pair of trousers or a skirt or to a quarter lining B attached to that part, the nonslip member A can maintain an extremely excellent nonslip effect for a long time. In addition, the nonslip member does not peel off after washing or dry cleaning. In addition, the manufacturing method according to claim 1 does not involve any base material referred to as a reinforcing piece used in the technique described in Japanese Patent No. 3417836, for example. Therefore, the method can manufacture a nonslip member that is substantially thinner than the nonslip members manufactured in the conventional methods and is not uncomfortable for users.

With the manufacturing method according to claim 2, when the two pack type urethane-based primer 3 in the molten state between the nonslip member 1 made of a silicone resin and the thermal adhesive resin film 4 and the thermal adhesive resin film 4 are heated in thermal adhesion treatment, the two layers can be strongly and uniformly pressed against each other by the pressing member, so that the nonslip member 1 made of a silicone resin and the thermal adhesive resin film 4 are in more intimate contact with each other and can be more firmly bonded to each other. In addition, any bubble between the primer 3 and the thermal adhesive resin film 4 can be expelled by the pressure from the pressing member, so that the appearance of the nonslip member is also improved.

With the nonslip member according to claim 3, since the nonslip member 1 made of a silicone resin and the thermal adhesive resin film 4 are firmly bonded to each other, when the nonslip member A is attached to the underside of the waist of a pair of trousers or a skirt or to the quarter lining B attached to that part, the nonslip member A can maintain an extremely excellent nonslip effect for a long time. In addition, the nonslip member A does not peel off after washing or dry cleaning. In addition, the nonslip member according to claim 3 does not include any base material referred to as a reinforcing piece used in the technique described in Japanese Patent No. 3417836, for example. Therefore, the nonslip member can be substantially thinner than the nonslip members manufactured in the conventional methods and is not uncomfortable for users.

According to the present invention described in claim 4, the nonslip member A, which is relatively small, can be extremely simply and efficiently manufactured from the sheet-shaped member having a wide area.

When the quarter lining B according to claim 5 is attached to the underside of the waist of a pair of trousers or a skirt, the nonslip member can maintain an extremely excellent nonslip effect for a long time. In addition, the nonslip member does not peel off after washing or dry cleaning.

### Brief Description of the Drawings

Figure 1 includes schematic enlarged views for illustrating a sequence of steps of an example of a method of manufacturing a nonslip member according to the present invention.
Figure 2 is an enlarged cross-sectional view showing an example of a layered structure of the nonslip member manufactured in the method of manufacturing a nonslip member according to the present invention.
Figure 3 is an enlarged front view showing parts of an example the nonslip member manufactured in the method of manufacturing a nonslip member according to the present invention attached to a quarter lining.
Figure 4 is an enlarged cross-sectional view showing the quarter lining shown in Figure 3 attached to the underside of the waist of a pair of trousers or a skirt.
Figure 5 is an enlarged cross-sectional view showing the nonslip member manufactured in the method of manufacturing a nonslip member according to the present invention directly attached to a part corresponding to the underside of the waist of a pair of trousers or a skirt.

### Description of Embodiments

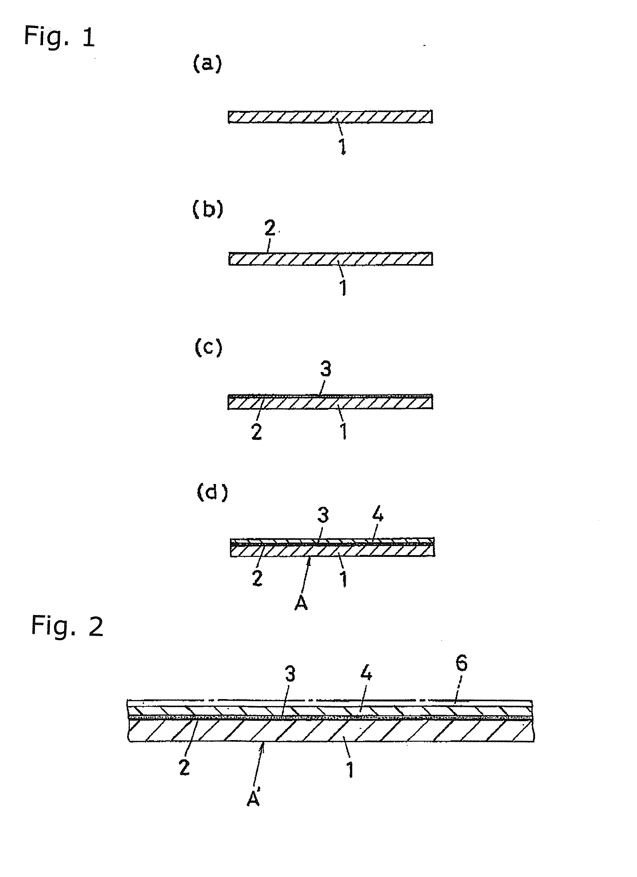

A method of manufacturing a nonslip member made of a silicone resin, a nonslip member manufactured in the same method and a quarter lining with the nonslip member attached thereto according to embodiments of the present invention will be described in detail with reference to Figures 1 to 5.

Figure 2 is an enlarged view showing an example of a layered structure of a nonslip member made of a silicone resin according to the present invention. The nonslip member having the layered structure can be easily manufactured by first molding a nonslip member 1 from a silicone resin as shown in Figure 1(a), treating the whole of one surface of the nonslip member 1 by combustion chemical vapor deposition 2 as shown in Figure 1(b), applying a two pack type urethane-based primer 3 in the molten state to the treated surface of the nonslip member 1 as shown in Figure 1(c), drying the primer 3, and then applying a thermal adhesive resin film 4 to the layer of the primer 3 by thermal adhesion treatment as shown in Figure 1(d).

As described above, one surface of the nonslip member 1 is treated by combustion chemical vapor deposition 2. In Figures 1(b) to 1(d) and Figure 2, the combustion chemical vapor deposition 2 is shown by a thick solid line. The two pack urethane-based primer 3 in the molten state is applied to the whole of the treated surface of the nonslip member 1 as shown in Figure 1(c) and dried, and the thermal adhesive resin film 4 is applied to the whole of the layer of the primer 3 by thermal adhesive treatment as shown in Figure 1(d).

The nonslip member 1 made of a silicone resin and the thermal adhesive resin film 4 are firmly bonded to each other after the primer 3 applied in the molten state is dried, and the thermal adhesive resin film 4 is applied to the layer of the primer 3 by thermal adhesion treatment. Results of tests for the adhesive strength, more specifically, for the peel strength and the dry cleaning resistance, have already been described and therefore will not be further described. In short, it is demonstrated that the nonslip member 1 made of a silicone resin and the thermal adhesive resin film 4 are firmly bonded to each other. Possible reasons for the firm adhesion are that the coating of the dried and cured two pack urethane-based primer 3 provides the nonslip member 1 serving as a base material with excellent adhesive properties, and that the coating has high flexibility.

Since the nonslip member 1 made of a silicone resin and the thermal adhesive resin film 4 are firmly bonded to each other as described above, when a nonslip member A is attached to the underside of the waist of a pair of trousers or a skirt or to a quarter lining B attached to that part, the nonslip member A can maintain an extremely excellent nonslip effect for a long time. In addition, the nonslip member A does not peel off after washing or dry cleaning.

Although the nonslip member A is shown enlarged in the drawings, the nonslip member A typically has an optical size of a dozen or so millimeters wide by three or four dozen or so millimeters long. The nonslip member A has an optical total thickness of 1 millimeter or so. However, when the nonslip member A is attached to the underside of the waist of a pair of trousers or a skirt or to the quarter lining B attached to that part, the nonslip member A can have a size somewhat larger or smaller than the value described above and a total thickness somewhat larger or smaller than the value described above.

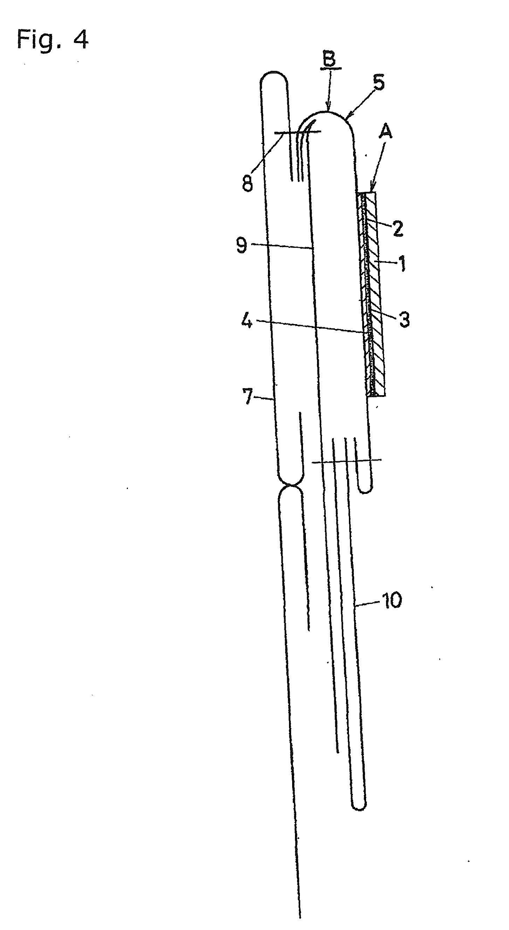

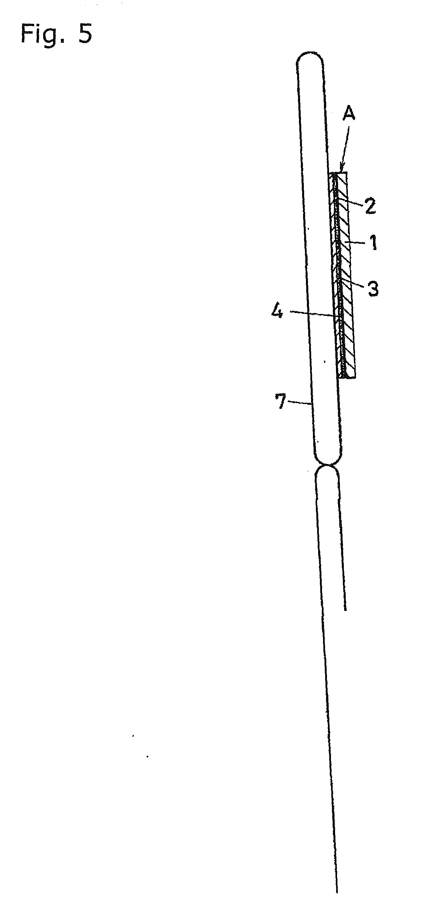

In this embodiment, a case will be described as an example where a nonslip surface (the bottom surface in Figures 1(d) and 2 or the right side surface in Figures 4 and 5) of the nonslip member 1 made of a silicone resin is flat. Although the nonslip surface is simply flat, the nonslip surface can exert a certain nonslip effect, since the silicone resin has adhesive properties. However, if the nonslip surface is treated to have irregularities, the nonslip effect of the nonslip surface increases.

Silicone is a polymer based on a chain of silicon atoms with organic groups linked by siloxane bonds (Si-O-Si), which can be artificially synthesized. The properties of silicone are classified into three basic forms: rubber, oil and resin. In this embodiment, a silicone classified as the rubber (liquid rubber) form is used. The liquid silicone rubber can not only be easily turned into an elastic body but also be susceptible to processing or treatment and therefore is used in a variety of applications. In this embodiment, the liquid silicone rubber is used as a material of the nonslip member for the quarter lining, and the nonslip member A can be extremely easily manufactured from the liquid silicone rubber in the molten state as described above.

The two pack urethane-based primer 3 is manufactured by synthesis of a urethane resin by reaction of a base resin and a curing agent. According to the most popular synthetic method, a polyol compound is used as a major constituent of the base resin, and an isocyanate compound is used as a major constituent of the curing agent. Although the specific examples of the primer 3 listed above include RUX manufactured by Seiko advance Ltd., SP-3100AU Clear manufactured by Teikoku Printing Inks Mfg. Co. Ltd., and AP ink and APG ink manufactured by Jujo Chemical Co. Ltd., the primer 3 is not limited thereto. Any two pack urethane-based primer containing at least a polyurethane resin, isophorone and methyl ethyl ketone probably has the same effect.

In this embodiment, when the thermal adhesive resin film 4 is applied to the whole of the layer of the primer 3 by thermal adhesion treatment, the thermal adhesive resin film 4 is vertically pressed against the layer of the primer 3 with a roller or other pressing member. In this case, when the two pack type urethane-based primer 3 in the molten state between the nonslip member 1 made of a silicone resin and the thermal adhesive resin film 4 and the thermal adhesive resin film 4 are heated in thermal adhesion treatment, the pressing member can strongly and uniformly press the two layers against each other, so that any bubble (air) can be expelled from between the two layers, and the nonslip member 1 made of a silicone resin and the thermal adhesive resin film 4 can be more firmly bonded to each other.

The thermal adhesive resin film 4 may be made of any commonly known material, such as an ethylene vinyl acetate (EVA) copolymer based material, a polyolefin (PO) based material, a polyamide (PA) based material, a synthetic rubber (SR) based material, an acrylic (ACR) based material, or a moisture curable polyurethane (PUR) based material.

The nonslip member having the layered structure shown in Figure 2 is preferably manufactured by providing a sheet-shaped member A' having a wide area, and cutting the sheet-shaped member A' into a predetermined size and a predetermined thickness with a cutting die, an embossing die or other equipment. In this case, the nonslip member A, which is relatively small, can be extremely simply and efficiently manufactured from the sheet-shaped member having a wide area. If release paper 6 is previously applied to the outer surface of the thermal adhesive resin film 4, the nonslip member A can be conveniently mounted on a belt body 5 by peeling the release paper 6 as required.

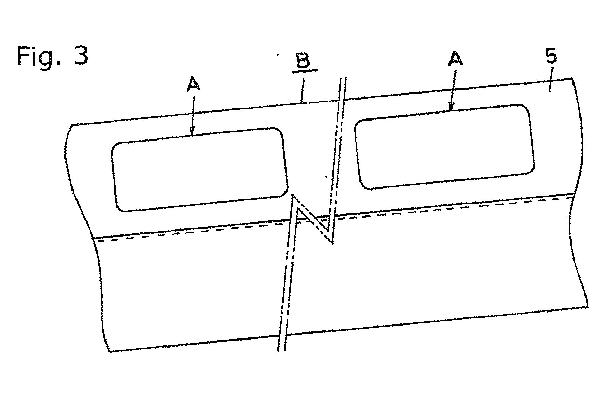

The thermal adhesive resin film 4 is made molten when the nonslip member A is heated to a predetermined temperature by an iron, a presser or other equipment. The melting temperature can be set at 120 to 150°C, for example. When the nonslip member A is heated to 120 to 150°C by an iron, a presser or other equipment, the thermal adhesive resin film 4 is made molten to form a thermal adhesive layer, and the nonslip member A can be extremely easily mounted on the belt body 5 attached to the underside of the waist of a pair of trousers or a skirt as shown in Figure 3, for example. The belt body is referred to as a quarter lining, which is denoted by reference symbol B in Figures 3 and 4.

The quarter lining B is attached to the underside of the waist of a pair of trousers or a skirt as shown in Figure 4, for example. In Figure 4, the quarter lining B is attached by sewing 8 to the underside of the waist of a pair of trousers or a skirt, which is opposite to outer fabric 7. In Figure 4, reference numeral 9 denotes padding fabric, and reference numeral 10 denotes bias fabric or other fabric.

The nonslip member A can be mounted to the belt body 5, which is to be attached to the underside of the waist of a pair of trousers or a skirt, to form the quarter lining B. As shown in Figure 4, if the quarter lining B is attached to the waist of a pair of trousers or a skirt, the nonslip member A exerts an extremely excellent nonslip effect. Alternatively, as shown in Figure 5, the nonslip member A may be directly attached to the underside of the waist of a pair of trousers or a skirt, which is opposite to the outer fabric 7. In that case, the nonslip member A also exerts an extremely excellent nonslip effect.

The method of manufacturing a nonslip member according to the present invention does not involve any base material referred to as a reinforcing piece used in the technique described in Japanese Patent No. 3417836, for example. Therefore, the method can manufacture a nonslip member that is substantially thinner than the nonslip members manufactured in the conventional methods and is not uncomfortable for users. In addition, the nonslip member according to the present invention does not include any base material referred to as a reinforcing piece used in the technique described in Japanese Patent No. 3417836, for example. Therefore, the nonslip member can be substantially thinner than the nonslip members manufactured in the conventional methods and is not uncomfortable for users.

If both the nonslip member 1 made of a silicone resin and the thermal adhesive resin film 4 are transparent, the nonslip member A is highly invisible and therefore can be effectively camouflaged in any of the cases where the nonslip member A is attached to the belt body 5 to be attached to the underside of the waist of a pair of trousers or a skirt, where the nonslip member A is attached to the quarter lining B attached to the underside of the waist of a pair of trousers or a skirt, and where the nonslip member A is directly attached to the underside of the waist of a pair of trousers or a skirt, which is opposite to the outer fabric 7.

A conventional nonslip member made of a rubber or a vinyl has no gas permeability. Therefore, it is difficult to perfectly bond the conventional nonslip member to the underside of the waist of a pair of trousers or a skirt by applying steam or heat to the nonslip member, and an additional operation of sewing or otherwise bonding the nonslip member to the underside of the waist of a pair of trousers or a skirt along the circumference thereof is required. However, with the nonslip member manufactured according to the present invention or the nonslip member according to the present invention, the thermal adhesive resin film 4 can be easily made molten and bonded to the underside of the waist of a pair of trousers or a skirt or the like by simply heating the nonslip member from the side of the nonslip member 1 made of a silicone resin. In addition, the thermal adhesive resin film 4 is extremely firmly bonded to the underside of the waist of a pair of trousers or a skirt, so that the nonslip member A does not peel off even if the pair of trousers or the skirt is washed or dry-cleaned.

### Reference Signs List

- 1: nonslip member
- 2: combustion chemical vapor deposition
- 3: primer
- 4: thermal adhesive resin film
- 5: belt body
- A: nonslip member
- B: quarter lining

## Claims

1. A method of manufacturing a nonslip member made of a silicone resin, **characterized in that** a surface of a nonslip member 1 made of a silicone resin is treated by combustion chemical vapor deposition, a two pack urethane-based primer 3 in a molten state is applied to the treated surface of the nonslip member 1 and dried, and a thermal adhesive resin film 4 is applied to the layer of the primer 3 by thermal adhesion treatment.

2. The method of manufacturing a nonslip member made of a silicone resin according to claim 1, **characterized in that** when the thermal adhesive resin film 4 is applied to the layer of the primer 3 by thermal adhesion treatment, the thermal adhesive resin film 4 is vertically pressed against the layer of the primer 3 with a roller or other pressing member.

3. A nonslip member made of a silicone resin, **characterized in that** the nonslip member comprises a nonslip member 1 made of a silicone resin a surface of which is treated by combustion chemical vapor deposition, a layer of a two pack urethane-based primer 3 provided on the treated surface, and a thermal adhesive resin film 4 applied to the layer of the primer 3.

4. The nonslip member according to claim 3, **characterized in that** the nonslip member has the shape of a sheet having a wide area, and the sheet-shaped member is processed into a predetermined size or thickness with a cutting die, an embossing die or other equipment.

5. A quarter lining, **characterized in that** a nonslip member A is mounted on a belt body 5 to be attached to an underside of a waist of a pair of trousers or a skirt, the nonslip member A comprising a nonslip member 1 made of a silicone resin a surface of which is treated by combustion chemical vapor deposition, a layer of a two pack urethane-based primer 3 provided on the treated surface, and a thermal adhesive resin film 4 applied to the layer of the primer 3.
